# EUROPEAN PATENT APPLICATION

(11) **EP 3 382 060 A1**
(43) Date of publication of application: **03.10.2018**
(21) Application number: 17164352.1
(22) Date of filing: 31.03.2017
(51) Int. Cl.: C23C 28/04, C23C 28/00, C23C 16/40, C23C 16/455

(54) **METHOD OF COATING A COMPONENT AND FLUID HANDLING COMPONENT APPARATUS**

(71) Applicant: Linde Aktiengesellschaft, 80331 München (DE)
(72) Inventor: Adam, Peter, 81369 München (DE)
(74) Representative: Richmond, Sarah

(57) **Abstract**

A method of coating a component to be wetted with a reactive fluid comprises depositing (302, 304, 306, 308) a seed layer of a first oxide adjacent a surface of the component. A layer of a second oxide and a layer of the first oxide are alternately deposited (310, 312, 314, 416, ...), thereby forming a multilayer conformal stack comprising the seed layer of the first oxide. The seed layer of the first oxide, the subsequent layers of the first oxide and the layers of the second oxide are deposited using an atomic layer deposition technique.

## Description

The present invention relates to a method of coating a component, the method being of the type that, for example, employs atomic layer deposition. The present invention also relates to a fluid handling component apparatus of the type that, for example, comprises a surface coated with layers of conformal material.

Gas is produced and supplied for a wide variety of applications, often on an industrial scale. The gas produced is stored, under pressure, in a pressure vessel, sometimes in liquefied form. Some industries, for example the semiconductor, photovoltaic and glass industries use highly reactive gases like hydrogen fluoride (HF), hydrogen chloride (HCl), hydrogen bromide (HBr), fluorine (F₂) and ammonia (NH₃). In order to protect the pressure vessel from corrosion, it is known to employ an Atomic Layer Deposition (ALD) process in order to coat the interior of the pressure vessel to protect the material of the pressure vessel exposed through internal surface of the pressure vessel from reacting with the fluid stored therein. Indeed, international patent publication no. WO 2015/132443 describes a process and apparatus for coating the internal surface of pressure vessels using the ALD technique.

However, certain components used with the pressure vessel are also wetted by the gas, for example pressure regulators. These components are typically formed from corrosion-resistant materials, for example type 316L stainless steel or a Monel^{®} alloy, but are not otherwise protected. These materials nevertheless tend to corrode over time when used with the above-mentioned gases, especially in combination with moisture (H₂O). Although International patent publication no. WO 2015/132443 mentioned above describes deposition of more than one layer of chemical compounds, the process disclosed does not identify the precise chemicals employed and the structure formed by deposition.

According to a first aspect of the present invention, there is provided a method of coating a component to be wetted with a reactive fluid, the method comprising: depositing a seed layer of a first oxide adjacent a surface of the component; depositing alternately a layer of a second oxide and a layer of the first oxide, thereby forming a multilayer conformal stack comprising the seed layer of the first oxide; wherein the seed layer of the first oxide, the subsequent layers of the first oxide and the layers of the second oxide are deposited using an atomic layer deposition technique.

The first oxide may be an oxide of a post-transition metal. The first oxide may be aluminium oxide.

The second oxide may be an oxide of a transition metal. The second oxide may be titanium dioxide or tantalum oxide.

The layers of aluminium oxide may be deposited using trimethylaluminium as a first precursor and water as a second precursor.

The layers of titanium dioxide may be deposited using titantetrachloride as a third precursor and water as a fourth precursor.

The layers of tantalum oxide may be deposited using tantalum ethoxide (Ta(OCH₂CH₃)₅) or tantalum chloride (TaCl₅) as a third precursor and water as a fourth precursor.

Each of the layers of the first oxide may be deposited to a thickness of between about 2 nm and about 30 nm. For example, the each of the layers of the first oxide may be deposited to a thickness of about 10 nm.

Each of the layers of the second oxide may be deposited to a thickness of between about 2 nm and about 30 nm. For example, the each of the layers of the second oxide may be deposited to a thickness of about 15 nm.

The multilayer conformal stack may be formed so as to have a thickness of between about 70 nm and about 180 nm. For example, the multilayer conformal stack may be formed so as to have a thickness of about 75 nm.

The multilayer conformal stack may comprise at least three layer of the first oxide and at least three layers of the second oxide.

A layer of the multilayer conformal stack furthest from the surface of the component may be formed from the second oxide.

The method may further comprise: pretreating the surface of the component with acetone followed by nitrogen gas.

The surface may be formed from a metal. The surface of the component may be formed from stainless steel or brass.

Deposition of the first oxide and/or the second oxide may be at a temperature of between about 125 °C and about 250 °C. Deposition of the first oxide and/or the second oxide may be at a pressure of between about 1 mbar to about 10 mbar.

According to a second aspect of the present invention, there is provided a fluid handling component apparatus for a gas supply apparatus, the component comprising: a surface coated with a multilayer conformal stack to protect against reaction with a fluid reactable with the surface, substantially all reactive sites on the surface being consumed by the multilayer conformal stack.

The multilayer conformal stack may comprise: a seed layer of a first oxide adjacent the surface; and alternate layers of a second oxide and the first oxide.

The first oxide may be an oxide of a post-transition metal. The first oxide may be aluminium oxide.

The second oxide may be an oxide of a transition metal. The second oxide may be titanium dioxide or tantalum oxide.

Each of the layers of the first oxide may be between about 20 nm and about 30 nm thick. For example, the each of the layers of the first oxide may be about 10 nm thick.

Each of the layers of the second oxide may be about 20 nm and about 30 nm thick. For example, the each of the layers of the second oxide may be about 15 nm thick.

The multilayer conformal stack may be between about 70 nm and about 100 nm thick. For example, the multilayer conformal stack may be about 75 nm thick.

The multilayer conformal stack may comprise at least three layers of the first oxide and at least three layers of the second oxide.

A layer of the multilayer conformal stack furthest from the surface may be formed from the second oxide.

The surface may be formed from stainless steel or brass. The surface may be part of a valve apparatus. The valve apparatus may be a gas pressure regulator. The surface may be part of a conduit.

According to a third aspect of the present invention, there is provided a fluid handling apparatus comprising a component having a surface coated with a multilayer conformal stack to protect against reaction with a fluid reactable with the surface.

According to a fourth aspect of the present invention, there is provided a method of coating a component to be wetted with a reactive fluid, the method comprising: depositing a seed layer of a first oxide adjacent a surface of the component; depositing a layer of a second oxide adjacent the seed layer of the first oxide, thereby forming a multilayer conformal stack comprising the seed layer of the first oxide; wherein the seed layer of the first oxide and the layer of the second oxide are deposited using an atomic layer deposition technique.

The first oxide may be an oxide of a post-transition metal. The first oxide may be aluminium oxide.

The second oxide may be an oxide of a transition metal. The second oxide may be titanium dioxide or tantalum oxide.

The layer of aluminium oxide may be deposited using trimethylaluminium as a first precursor and water as a second precursor.

The layer of titanium dioxide may be deposited using titantetrachloride as a third precursor and water as a fourth precursor.

The layer of tantalum oxide may be deposited using tantalum ethoxide (Ta(OCH₂CH₃)₅) or tantalum chloride (TaCl₅) as a third precursor and water as a fourth precursor.

According to a fifth aspect of the present invention, there is provided a fluid handling component apparatus for a gas supply apparatus, the component comprising: a surface coated with a layer of a first oxide adjacent the surface and a layer of a second oxide adjacent the layer of the first oxide so as to form a multilayer conformal stack to protect against reaction with a fluid reactable with the surface; wherein substantially all reactive sites on the surface are consumed by the multilayer conformal stack.

The first oxide may be an oxide of a post-transition metal. The first oxide may be aluminium oxide.

The second oxide may be an oxide of a transition metal. The second oxide may be titanium dioxide or tantalum oxide.

It is thus possible to provide a method and apparatus that obviates or at least mitigates corrosion of a surface of a component used in relation to gas handling. By coating one or more surfaces that are wetted by reactive gas during use, it is also possible to allow use of components, for example cylinder valves, to be manufactured from lower cost materials than specific corrosion resistant alloys, for example low cost stainless steel or brass. Indeed, such components have similar or better properties than valves which are made from the more costly corrosion resistant materials, for example 316L type stainless steel or a Monel^{®} alloy.

At least one embodiment of the invention will now be described, by way of example only, with reference to the accompanying drawings, in which:
Figure 1 is a schematic diagram of an atomic layer deposition system used to coat a surface of a component in accordance with an embodiment of the invention;
Figure 2 is a schematic diagram of a component having a conformally coated surface constituting an embodiment of the invention; and
Figure 3 is a flow diagram of a method of coating a component constituting another embodiment of the invention.

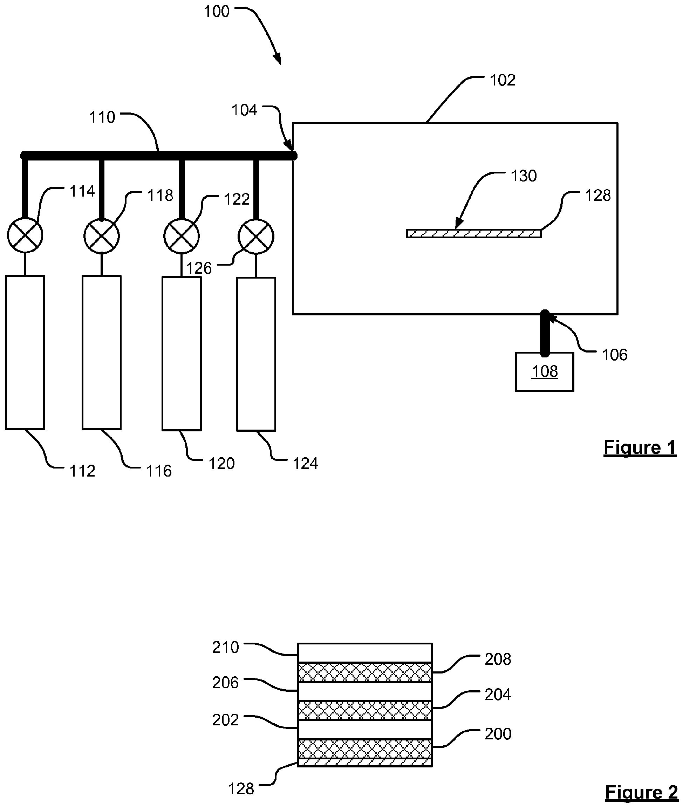

Referring to Figure 1, an Atomic Layer Deposition (ALD) system 100 comprises a reactor chamber 102 having an inlet port 104 and an outlet port 106. The outlet port 106 is operably coupled to a turbo molecular pump 108 via a conduit. The inlet port 104 is operably coupled to a manifold 110, the manifold 110 being operably coupled to a first pressure vessel 112, for example a cylinder, containing a first precursor compound via a first high-speed valve 114. The manifold 110 is also operably coupled to a second pressure vessel 116, for example a cylinder, containing a second compound via a second high-speed valve 118. In this example, the second compound serves as a second and fourth precursor compound. A third pressure vessel 120, for example a cylinder, is operably coupled to the manifold 110 via a third high-speed valve 122 and contains a third precursor compound. A fourth pressure vessel 124, for example a cylinder, is also operably coupled to the manifold 110 via a fourth valve 126 and contains a purge gas. Although not shown, the valves 114, 118, 122, 126, the turbo molecular pump 108 and a rotary fan (not shown) are, in this example, under computer control.

A component 128 to be coated is provided in the reactor chamber 102. The component to be coated has a surface 130. The component 128 is, in this example, any part that requires a conformal coating to protect the component 128 when wetted with a reactive fluid, for example a gas. In this respect, the component 128 is part of a fluid handling apparatus, for example a valve, such as a pressure regulator valve. However, the skilled person should appreciate that components of other apparatus for use when handling reactive fluids is contemplated. In this regard, components used in relation to filling pressure vessels and drawing fluids from pressure vessels can require a suitable conformal coating. This can include conduits, for example pipes, used to convey fluid from one location and/or apparatus to another, or other parts or components for example pressure regulators, such as a body of a regulator and/or a membrane of the regulator, shut-off valves, and/or needle valves. In this example, the component 128 is formed from a metal, for example stainless steel. However, brass can alternatively be employed.

Turning to Figure 2, when coated, the surface 130 comprises a first layer of aluminium oxide (AlO₃) 200 disposed thereon. The first layer of aluminium oxide 200 adjacent the surface 130 of the component constitutes a seed layer. A first layer of titanium dioxide (TiO₂) 202 is disposed adjacent the first layer of alumiunium oxide. The first layer of aluminium oxide 200 and the first layer of titanium dioxide 202 constitute a multilayer conformal stack. In some examples, this number of different layers of oxide provides a sufficiently robust conformal coating for the surface 130 to obviate or mitigate corrosion of the surface 130 when wetted with reactive gases. However, in this example, the multilayer conformal stack comprises further alternating layers of oxides, for example aluminium oxide and titanium dioxide. In this regard, a second layer of aluminium oxide 204 is disposed adjacent the first layer of titanium dioxide 202 and a second layer of titanium dioxide 206 is disposed adjacent the second layer of aluminium oxide 204. A third layer of aluminium oxide 208 is disposed adjacent the second layer of titanium dioxide 206 and a third layer of titanium dioxide 210 is disposed adjacent the third layer of aluminium oxide 208.

In this example, the uppermost layer is formed from the second of the two oxides employed, namely titanium dioxide.

By coating the surface 130 of the component 128 with the multilayer conformal stack, substantially all reactive sites on the surface 130 are consumed by the multilayer conformal stack.

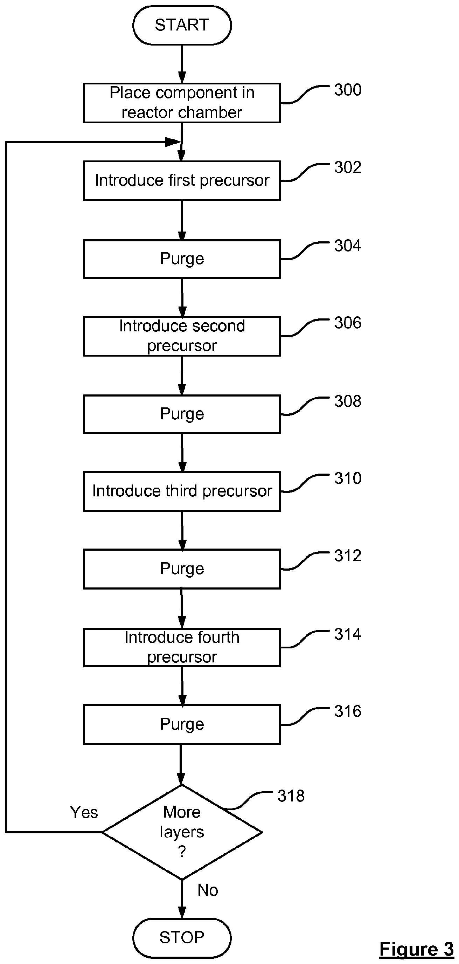

Referring also to Figure 3, the multilayer conformal stack coating is formed as follows using any suitable atomic layer deposition technique and the one described herein is provided purely by way of example.

The component 128 is firstly prepared by pretreating the surface 130 of the component with acetone, followed by nitrogen gas. The component 128 is then placed (Step 300) in the reactor chamber 102 and the chamber 102 is purged by creating a vacuum in the chamber 102 using a rotary pump (not shown). A vacuum is then maintained within the chamber and the chamber 102 is heated. The pressure established within the chamber 102 can be between about 1 mbar and about 10 mbar. In this example, the pressure within the chamber is about 5 mbar. The chamber 102 can have an internal temperature of between about 125 °C and 250 °C. In this example, the temperature is about 125 °C.

The first precursor compound is then introduced (Step 302) from the first pressure vessel 112 into the chamber 102 using a pulse of the first high-speed valve 114. In this example, the first precursor compound is trimethylaluminium (AlCH₃)₃. After a first predetermined period of time, corresponding to depositing sufficient trimethylauminium to achieve a desired thickness for the first layer of aluminium oxide 200, the chamber 102 is evacuated (Step 304) by actuating the fourth valve 126 to release the purge gas, for example nitrogen, argon or any other suitable purge gas, into the chamber 102 and evacuating the chamber 102 using the turbo molecular pump 108. This therefore leaves the surface 130 coated with trimethylaluminium. The second high-speed valve 118 is then pulsed to introduce (Step 306) the second precursor compound, water (H₂O), into the chamber 102. The second valve 118 is open for a second predetermined period of time sufficient to allow substantially all reactive sites of the trimethylaluminium to be consumed. In this example, the trimethylalumium is hydrolysed by the water. Once hydrolysed, the first layer of aluminium oxide 200 mentioned above is formed on the surface 130. The chamber 102 is once again evacuated (Step 308) by actuating the fourth valve 126 to release the purge gas into the chamber 102 and evacuating the chamber 102 using the turbo molecular pump 108. The first layer of aluminium oxide 200 can be deposited to a thickness of between about 2 nm and about 30 nm. In this example, the first layer of aluminium oxide 200 is formed to a thickness of about 10 nm.

Once purged, the surface 130 carrying the first layer of aluminium oxide 200 is ready for formation of the first layer of titanium dioxide 202 adjacent the first layer of aluminium oxide 200. The third precursor compound is then introduced (Step 310) from the third pressure vessel 120 into the chamber 102 using a pulse of the third high-speed valve 122. In this example, the third precursor compound is titaniumtetrachloride (TiCl₄). After a third predetermined period of time, corresponding to depositing sufficient titaniumtetrachloride to achieve a desired thickness for the first layer of titanium dioxide 202, the chamber 102 is evacuated (Step 312) by actuating the fourth valve 126 to release the purge gas into the chamber 102 and evacuating the chamber 102 using the turbo molecular pump 108. This therefore leaves the surface 130 coated with titaniumtetrachloride. The second high-speed valve 118 is then pulsed to introduce (Step 314) the fourth precursor compound, water (H₂O), into the chamber 102. The second valve 118 is open for a fourth predetermined period of time sufficient to allow substantially all reactive sites of the titaniumtetrachloride to be consumed. In this example, the titaniumtetrachloride is hydrolysed by the water. Once hydrolysed, the first layer of titanium dioxide 202 mentioned above is formed on the first layer of aluminium oxide 200. The chamber 102 is once again evacuated (Step 316) by actuating the fourth valve 126 to release the purge gas into the chamber 102 and evacuating the chamber 102 using the turbo molecular pump 108. The first layer of titanium dioxide 202 can be deposited to a thickness of between about 2 nm and about 30 nm. In this example, the first layer of titanium dioxide 202 is formed to a thickness of about 15 nm.

It is then determined (Step 318) whether further layers of aluminium oxide and titanium dioxide need to be deposited as part of the formation of the multilayer conformal stack. If no further layers need to be deposited, the process is halted and the component 128 carrying the multilayer conformal stack is removed from the reaction chamber 102. Otherwise, if further layers of aluminium oxide and titanium dioxide are to be deposited, the above described process is repeated (Steps 302 to 316) until a required number of alternating layers is formed on the surface 130 of the component 128.

The skilled person should appreciate that the above-described implementations are merely examples of the various implementations that are conceivable within the scope of the appended claims. Indeed, although in this example, aluminium oxide and titanium dioxide are employed, other oxides can be employed. For example, oxides of post-transitional metals and oxides of transition metals can be employed, such as tantalum oxide. Where tantalum oxide is used, tantalum ethoxide (Ta(OCH₂CH₃)₅) or tantalum chloride (TaCl₅) is used as one precursor and the precursor is hydrolysed with water (H₂O), which is employed as the other precursor. The above temperature and pressure conditions can be employed in relation to forming the tantalum oxide.

Furthermore, although in the above example the total thickness of the multilayer conformal stack is about 75 nm, the multilayer conformal stack can have a thickness between about 70 nm and about 180 nm. In the above example, the multilayer conformal stack comprises three layers of aluminium oxide and three layers of titanium dioxide, a greater number of layers of a first oxide and a greater number of layers of a second oxide can be employed, for example at least three layers of the first oxide and at least three layers of the second oxide.

Although the above examples have been described in the context of gases, the skilled person should appreciate that fluids can be employed.

## Claims

1. A method of coating a component (128) to be wetted with a reactive fluid, the method comprising:
depositing (302, 304, 306, 308) a seed layer (200) of a first oxide adjacent a surface (130) of the component (128);
depositing alternately a layer of a second oxide (310, 312, 314, 316) and a layer of the first oxide (302, 304, 306, 308), thereby forming a multilayer conformal stack (200, 202, 204, 206, 208, 210) comprising the seed layer (200) of the first oxide; wherein
the seed layer (200) of the first oxide, the subsequent layers of the first oxide and the layers of the second oxide (202, 204, 206, 208, 210) are deposited using an atomic layer deposition technique.

2. A method as claimed in Claim 1, wherein the first oxide is an oxide of a post-transition metal.

3. A method as claimed in Claim 1 or Claim 2, wherein the first oxide is aluminium oxide.

4. A method as claimed in Claim 1 or Claim 2 or Claim 3, wherein the second oxide is an oxide of a transition metal.

5. A method as claimed in Claim 4, wherein the second oxide is titanium dioxide.

6. A method as claimed in Claim 4, wherein the second oxide is tantalum oxide.

7. A method as claimed in Claim 3, wherein
the layers of aluminium oxide (200, 204, 208) are deposited using trimethylaluminium as a first precursor and water as a second precursor.

8. A method as claimed in Claim 5, wherein
the layers of titanium dioxide (202, 206, 210) are deposited using titantetrachloride as a third precursor and water as a fourth precursor.

9. A method as claimed in any one of the preceding claims, wherein each of the layers of the first oxide (200, 204, 208) is deposited to a thickness of between about 2 nm and about 30 nm.

10. A method as claimed in any one of the preceding claims, wherein each of the layers of the second oxide (202, 206, 210) is deposited to a thickness of between about 2 nm and about 30 nm.

11. A method as claimed in any one of the preceding claims, wherein the multilayer conformal stack is formed so as to have a thickness of between about 70 nm and about 180 nm.

12. A method as claimed in any one of the preceding claims, wherein the multilayer conformal stack comprises at least three layer of the first oxide (200, 204, 208) and at least three layers of the second oxide (202, 206, 210).

13. A fluid handling component apparatus for a gas supply apparatus, the component comprising:
a surface (130) coated with a multilayer conformal stack to protect against reaction with a fluid reactable with the surface, substantially all reactive sites on the surface (130) being consumed by the multilayer conformal stack.

14. A fluid handling apparatus comprising a component (128) having a surface (130) coated with a multilayer conformal stack to protect against reaction with a fluid reactable with the surface (130).

15. A method of coating a component (128) to be wetted with a reactive fluid, the method comprising:
depositing a seed layer (200) of a first oxide (302, 304, 306, 308) adjacent a surface (130) of the component (128);
depositing a layer of a second oxide (310, 312, 314, 316) adjacent the seed layer (200) of the first oxide, thereby forming a multilayer conformal stack (200, 202, 204, 206, 208, 210) comprising the seed layer (200) of the first oxide; wherein
the seed layer (200) of the first oxide and the layer of the second oxide (202) are deposited using an atomic layer deposition technique.
